# EUROPEAN PATENT SPECIFICATION

(11) **EP 3 364 452 B1**
(45) Date of publication and mention of the grant of the patent: **14.08.2019**
(21) Application number: 18155589.7
(22) Date of filing: 07.02.2018
(51) Int. Cl.: H01L 23/467

(54) **AIR-COOLING HEAT DISSIPATION DEVICE**
LUFTKÜHLUNGSWÄRMEABLEITUNGSVORRICHTUNG
DISPOSITIF DE DISSIPATION DE CHALEUR À REFROIDISSEMENT PAR AIR

(30) Priority: 20.02.2017 TW 106105639
(43) Date of publication of application: 22.08.2018
(73) Proprietor: Microjet Technology Co., Ltd, Hsinchu (TW)
(72) Inventor: LIAO, Jia-Yu, Hsinchu (TW); CHEN, Shih-Chang, Hsinchu (TW); HUANG, Chi-Feng, Hsinchu (TW); HAN, Yung-Lung, Hsinchu (TW)
(74) Representative: 2K Patentanwälte Blasberg Kewitz & Reichel

(56) References cited:
- EP-A1- 2 998 582
- EP-A2- 1 020 911
- WO-A1-2016/038321
- CN-A- 104 234 986
- JP-A- 2014 240 662
- TW-U- M 530 883
- US-A1- 2013 135 823

## Description

### FIELD OF THE INVENTION

The present invention relates to an air-cooling heat dissipation device, and more particularly to an air-cooling heat dissipation device using an air pump to produce an air flow to remove heat.

### BACKGROUND OF THE INVENTION

With increasing development of science and technology, the trends of designing electronic devices such as portable computers, tablet computers, industrial computers, portable communication devices or video players are designed toward minimization, easy portability and high performance. Generally, the limited space inside the electronic device is equipped with various high-integration or high-power electronic components for increasing the computing speed and the function of the electronic device, thus generating a great deal of heat during operations. Consequently, the temperature inside the device is increased and high temperature is harmful to the components. Since the electronic device is usually designed as possible as in slim, flat and succinct appearance, it has insufficient inner space for dissipating the waste heat. In case that the heat is not effectively dissipated away, the electronic components of the electronic device are adversely affected by the heat and the high temperature may result in the interference of operation or damaged of the device.

Generally, there are two types of the heat-dissipating mechanisms used in the electronic device to solve such problem, which are known as active heat-dissipating mechanism and passive heat-dissipating mechanism. The active heat-dissipating mechanism is usually presented as an axial fan or a blower, disposed within the electronic device, which can generate an air flow through the space inside the electronic device that dissipating the waste heat. However, the axial fan and the blower are noisy during operation. In addition, they are bulky and have short life span and not suitable to be used in the small-sized, portable electronic device.

On the other hand, electronic components are generally fixed on a printed circuit board (PCB) by means of surface mount technology (SMT) or selective soldering technology. The electronic components would readily come off from the PCB board due to exposure of high temperature. Moreover, most electronic components would be damaged by high temperature. In other words, high temperature not only impairs the stability of performance of the electronic components, but also shortens the life span of the electronic components.

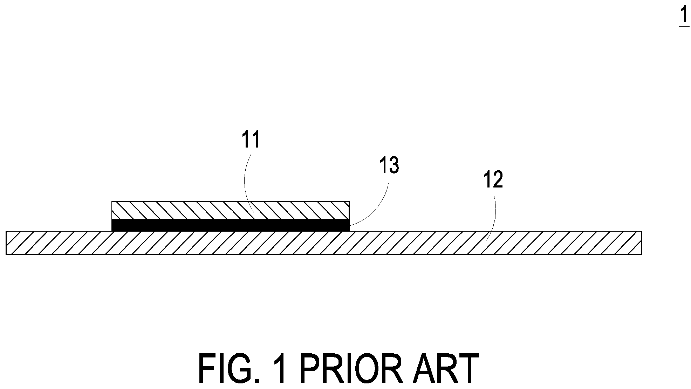

FIG. 1 is a schematic view illustrating a conventional heat-dissipating mechanism as the passive heat-dissipating mechanism. As shown in FIG. 1, the conventional heat-dissipating mechanism 1 provides a thermal conduction plate 12 attaching on a surface of an electronic component 11 by thermal adhesive 13. Therefore, the thermal adhesive 13 and the thermal conduction plate 12 form a thermal conduction path by which the waste heat generated by the electronic component 11 can be conducted away and then dissipated by convection. However, the heat dissipating efficiency of the conventional heat-dissipating mechanism 1 is usually insufficient, and thus the applications of the conventional heat-dissipating mechanism 1 are limited.

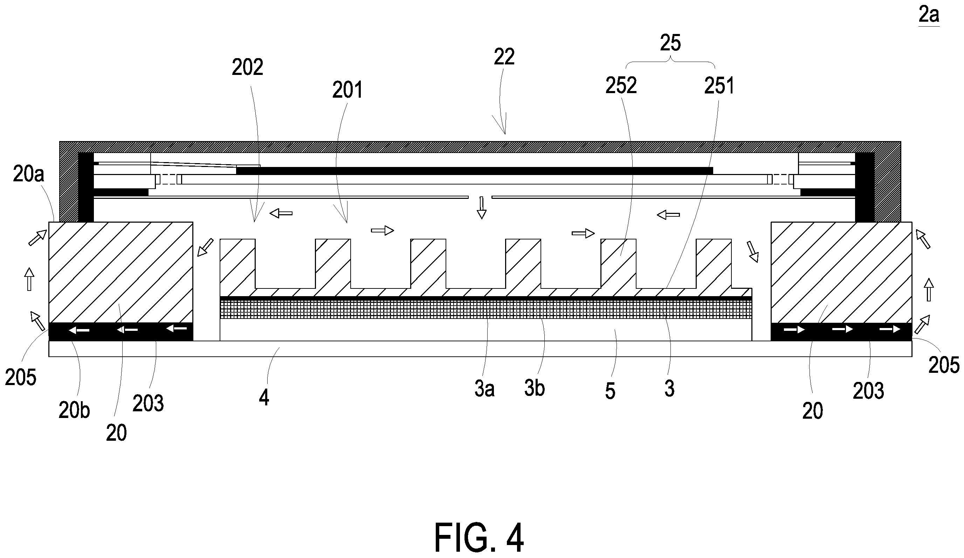

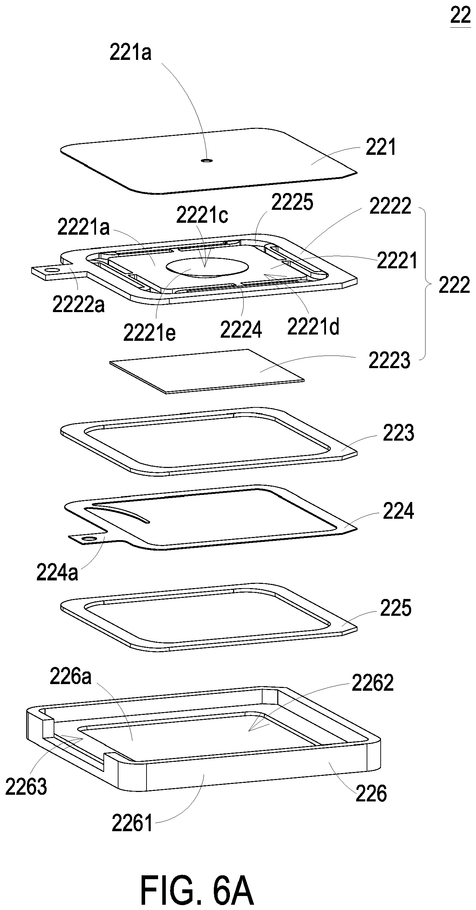

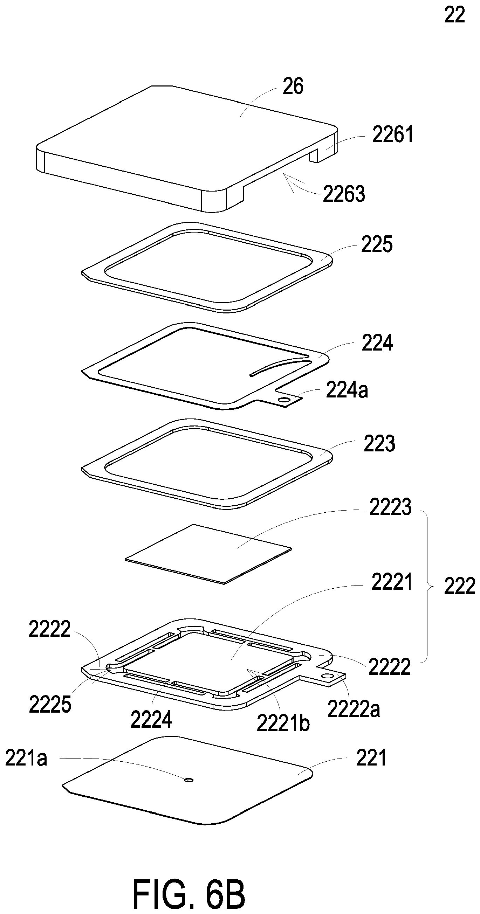

US 2013/135823 A1 discloses discloses a semiconductor package usable with a mobile device. As shown there in the FIG. 4 and 6, the semiconductor package 510 includes a circuit board 100, an integrated circuit chip 200, a cover 300 and an air flow generator 400. The circuit board 100 includes conductive wirings 110 therein and contact terminals 630 on a rear surface thereof. The integrated circuit chip 200 is positioned on a front surface of the circuit board 100 and electrically connected to the conductive wirings 110. The cover 300 includes at least one opening 310 or 320, and to cover the integrated circuit chip 200 such that a flow space S is provided around the integrated circuit chip 200 and the opening 310 or 320 communicates with the flow space S. The air flow generator 400 positioned on the cover 300 to generate a compulsory air flow through the flow space S and the opening 310 or 320, thereby dissipating heat out of the semiconductor package 500 from the integrated circuit chip 200 by the compulsory air flow.

EP 2 998 582 A1 discloses a micro-gas pressure driving device. As shown there in the FIG. 1A, the micro-gas pressure driving device 1 includes a miniature gas transportation module 1A, a covering plate 10 and a tube plate 11. The miniature gas transportation module 1A includes a convergence plate 12, a resonance membrane 13 and a piezoelectric actuator 14. When the piezoelectric actuator 14 is activated to feed a gas into an input tube 11a of the tube plate 11, the gas is sequentially transferred through a first input chamber 111, a second input chamber 100, an inlet 120, a convergence channel 123 and a central opening 124 of the convergence plate 12, a central aperture 130 of the resonance membrane 13, and transferred downwardly through the piezoelectric actuator 14 and an output chamber 112, and outputted from an output tube 11b of the tube plate 11. The first input chamber 111 is arranged between the covering plate 10 and the input tube 11a. The second input chamber 100 is defined between the covering plate 10 and the convergence plate 12. The output chamber 112 is defined between the tube plate 11 and the piezoelectric actuator 14.

EP 1 020 911 A2 discloses an apparatus for cooling an electronic device. As shown there in the FIG. 2A, the apparatus includes a case 30, a plate type mobile member 34, an elastic support film 33, a driving device 35, 36. The case 30 has a plurality of air intake/exhaust holes 38a, 38b for passing air therethrough. The plate type mobile member 34 is installed to vibrate in the case 30 and divides an inner space of the case 30 into an upper space 30a and a lower space 30b. The elastic support film 33 is fixed in the case 30 to support the mobile member 34 and has a bulged portion 33b capable of being elastically deformed. A driving device 35, 36 is for vibrating the mobile member 34. By the vibration of the mobile member 34, air in the upper and lower spaces 30a, 30b of the case 30 is exchanged with outside air through the air intake/exhaust holes 38a, 38b so that a heat source is cooled.

TW M 530 883 U discloses a control system for the ignition of a vehicle consisting of a centrifugal clutch (26), or a continuous transmission drive, of the belt type (20), in which the driving force of a motor (E) is transmitted to a driving wheel (Wr) by the intermediary of the clutch or continuous belt drive. The control system consists of an acceleration sensor, designed to detect the state of the acceleration of the vehicle, a device for retarding the ignition, which is designed to retard the adjustment of the ignition, when acceleration is detected and a second device for retarding the ignition, which is designed to apply a retard adjustment after acceleration is detected.

Therefore, there is a need of providing an air-cooling heat dissipation device with improved performance as well as compact size to substitute the conventional technologies.

### SUMMARY OF THE INVENTION

An object of the present invention provides an air-cooling heat dissipation device. The air-cooling heat dissipation device is applied to an electronic device to remove heat generated by electronic components of the electronic device through creating circulatory heat convection. The use of the air-cooling heat dissipation device can increase the heat dissipating efficiency and prevent unacceptable noise. Consequently, the performance of the electronic components of the electronic device is stabilized, and the life spans of the electronic components are extended.

Another object of the present invention provides an air-cooling heat dissipation device with a temperature controlling function. The operations of an air pump are controlled according to the temperature changes of the electronic components of the electronic device. Consequently, the heat dissipating efficiency is enhanced, and the life span of the air pump is extended.

In accordance with an aspect of the present invention, an air-cooling heat dissipation device is provided for removing heat from an electronic component. The air-cooling heat dissipation device includes an air pump comprising a resonance plate having a central aperture, and a piezoelectric actuator aligned with the resonance plate. The air-cooling heat dissipation device further comprises a guiding carrier and an air pump. The guiding carrier includes a first surface, a second surface, an accommodation chamber, an introduction opening and plural discharge grooves. The accommodation chamber runs through the first surface and the second surface. The introduction opening is formed in the first surface and in communication with the accommodation chamber. The plural discharge grooves are formed in the second surface and in communication between the accommodation chamber and exterior surroundings. The electronic component is accommodated within the accommodation chamber. The air pump further comprises a covering member having a sidewall, a bottom plate and an opening. The sidewall is protruding from the edge of the bottom plate, an accommodation space is defined by the bottom plate and the sidewall collaboratively, the resonance plate and the piezoelectric actuator are disposed within the accommodation space, and the opening is formed on the sidewall. A first chamber is formed between the resonance plate and the bottom plate of the covering member, and a convergence chamber is defined by the resonance plate and the sidewall of the covering member collaboratively. The covering member, the piezoelectric actuator and the resonance plate are stacked and fixed on the guiding carrier sequentially and seal the introduction opening. When the piezoelectric actuator is enabled to perform a gas-collection operation, a gas is introduced into the gas pump through the opening of the covering member and converged to the convergence chamber, and then the gas is transferred to and temporarily stored in the first chamber through the central aperture of the resonance plate. When the piezoelectric actuator is enabled to perform an gas-releasing operation, the gas flows from the first chamber to the convergence chamber through the central aperture of the resonance plate and then the gas is introduced into the accommodation chamber through the introduction opening such that an air flow is generated to remove heat from the electronic component, after which the heated air flow is discharged through the plural discharge grooves.

In accordance with a further aspect of the present invention, the air-cooling heat dissipation device may further comprise a heat sink attached on the electronic component and disposed within the accommodation chamber.

In accordance with a further aspect of the present invention, the air-cooling heat dissipation device may further comprise a heat pipe attached on the electronic component and disposed within the accommodation chamber.

The above contents of the present invention will become more readily apparent to those ordinarily skilled in the art after reviewing the following detailed description and accompanying drawings, in which:

### BRIEF DESCRIPTION OF THE DRAWINGS

FIG. 1 is a schematic view illustrating a conventional heat-dissipating mechanism;
FIG. 2A is a schematic perspective view illustrating the structure of an air-cooling heat dissipation device according to a first embodiment of the present invention;
FIG. 2B is a schematic cross-sectional view illustrating the air-cooling heat dissipation device of FIG. 2A and taken along the line AA';
FIG. 3 is a schematic cross-sectional view illustrating a guiding carrier of the air-cooling heat dissipation device as shown in FIG. 2A;
FIG. 4 is a schematic cross-sectional view illustrating an air-cooling heat dissipation device according to a second embodiment of the present invention;
FIG. 5 is a schematic cross-sectional view illustrating an air-cooling heat dissipation device according to a third embodiment of the present invention;
FIG. 6A is a schematic exploded view illustrating an air pump used in the air-cooling heat dissipation device of the present invention and taken along the rear side;
FIG. 6B is a schematic exploded view illustrating the air pump of FIG. 6A and taken along the front side;
FIG. 7 is a schematic cross-sectional view illustrating a piezoelectric actuator of the air pump as shown in FIGS. 6A and 6B;
FIGS. 8A to 8D schematically illustrate the actions of the air pump of FIGS. 6A and 6B; and
FIG. 9 is a schematic cross-sectional view illustrating an air-cooling heat dissipation device according to a fourth embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

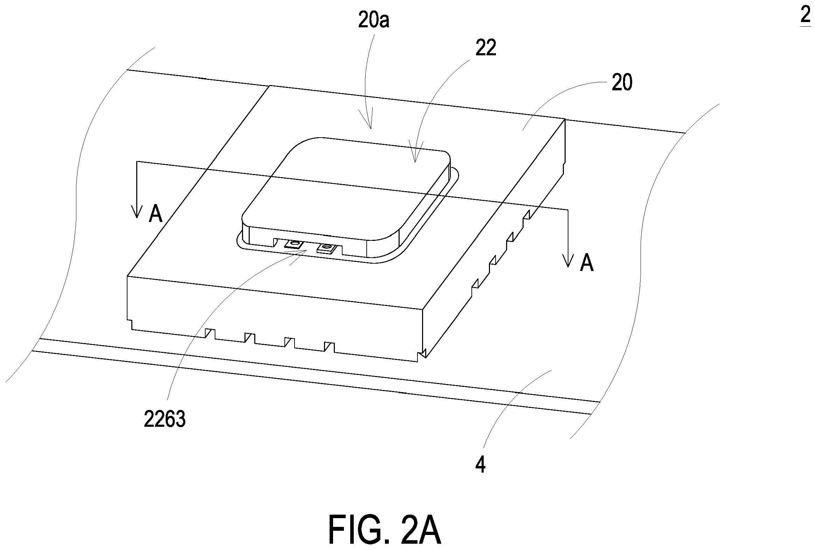

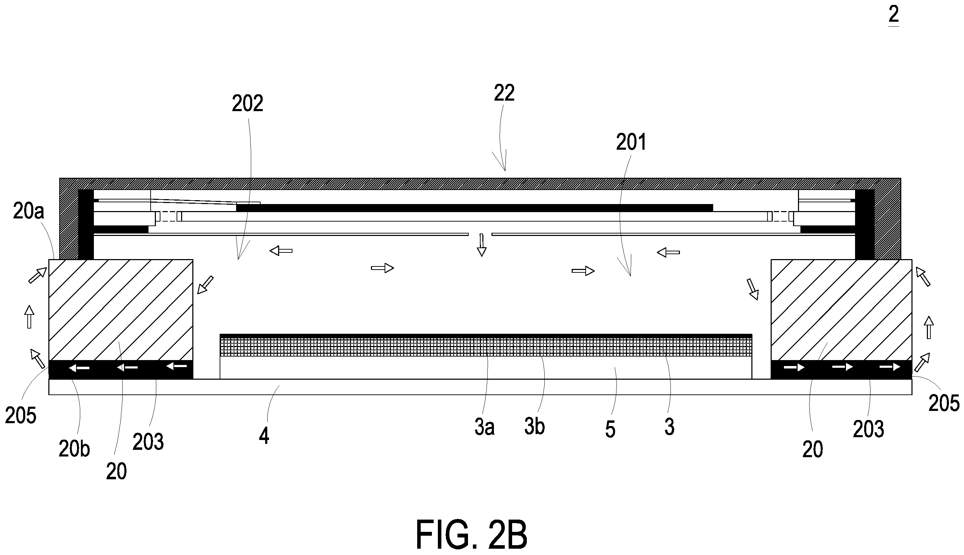

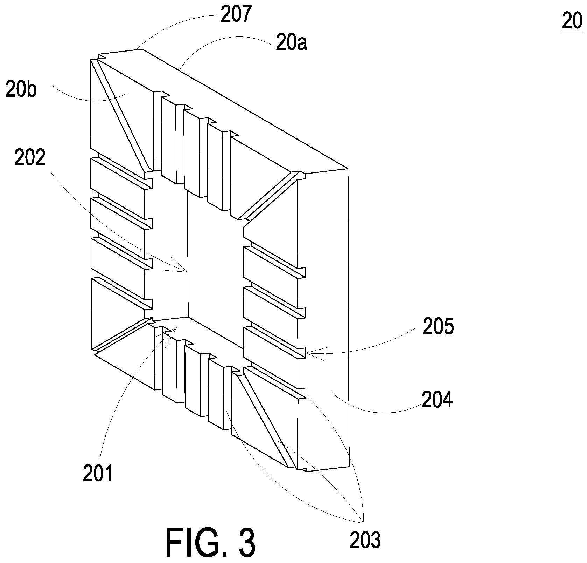

FIG. 2A is a schematic perspective view illustrating the structure of an air-cooling heat dissipation device according to a first embodiment of the present invention. FIG. 2B is a schematic cross-sectional view illustrating the air-cooling heat dissipation device of FIG. 2A and taken along the line AA'. FIG. 3 is a schematic cross-sectional view illustrating a guiding carrier of the air-cooling heat dissipation device as shown in FIG. 2A. Please refer to FIGS. 2A, 2B and 3. The air-cooling heat dissipation device 2 is applied to an electronic device to remove the heat from an electronic component 3 of the electronic device. An example of the electronic device includes but is not limited to a portable computer, tablet computer, an industrial computer, a portable communication device or video player.

The air-cooling heat dissipation device 2 comprises a guiding carrier 20 and an air pump 22. The guiding carrier 20 comprises a first surface 20a, a second surface 20b, an accommodation chamber 201, an introduction opening 202 and plural discharge grooves 203. The accommodation chamber 201 runs through the first surface 20a and the second surface 20b. The introduction opening 202 is formed in the first surface 20a and in communication with the accommodation chamber 201. The plural discharge grooves 203 are formed in the second surface 20b for allowing air to go through. A first end of each discharge groove 203 is in communication with the accommodation chamber 201, while a second end of each discharge groove 203 is extended to lateral surfaces 204 of the guiding carrier 20 and in communication with the exterior surroundings. Consequently, plural vents 205 are formed on the lateral surfaces 204 of the guiding carrier 20. The electronic component 3 is accommodated within the accommodation chamber 201 of the guiding carrier 20. The air pump 22 is fixed on the first surface 20a of the guiding carrier 20. Moreover, the air pump 22 is coupled with the introduction opening 202 and seals the edge of the introduction opening 202. When the air pump 22 is activated, the ambient air is introduced into the accommodation chamber 201 of the guiding carrier 20 through the introduction opening 202 to exchange heat with the electronic component 3 so as to remove heat from the electronic component 3. After the heat exchange, the heated air is exhausted to the surroundings through the plural discharge grooves 203. Consequently, the heat dissipation of the electronic component 3 is achieved.

Preferably but not exclusively, the guiding carrier 20 has a frame structure. In this embodiment, the introduction opening 202 is located at a central region of the first surface 20a. The electronic component 3 has a first surface 3a and an opposing second surface 3b, and is disposed on a supporting substrate 4 by the second surface 3b mounted. Preferably but not exclusively, the supporting substrate 4 is a printed circuit board. A thermally conductive adhesive 5 is disposed between the second surface 3b of the electronic component 3 and the supporting substrate 4. Namely, the electronic component 3 is fixed on the supporting substrate 4 by thermally conductive adhesive 5, but not limited thereto. The supporting substrate 4 is connected to the second surface 20b of the guiding carrier 20 to make the electronic component 3 received within the accommodation chamber 201 of the guiding carrier 20. The plural discharge grooves 203 are formed in the second surface 20b of the guiding carrier 20. In this embodiment, as shown in FIG. 3, the plural discharge grooves 203 are arranged in a radial form. More specifically, some of the second ends of the plural discharge grooves 203 are formed in the lateral surfaces 204 of the guiding carrier 20, while some other second ends of the discharge grooves 203 are formed in plural corners 207 of the guiding carrier 20. Consequently, the air can be exhausted to the surroundings through the periphery region of the guiding carrier 20.

In some embodiments of the present invention, the air pump 22 is a piezoelectric air pump for generating air flow, and is fixed on the first surface 20a of the guiding carrier 20. Moreover, the air pump 22 is coupled with the introduction opening 202 as sealing the edge of the introduction opening 202. The supporting substrate 4 is attached on the second surface 20b of the guiding carrier 20. In other words, the supporting substrate 4 is covered by the combination of the guiding carrier 20 and the air pump 22. Consequently, the electronic component 3 is accommodated within the accommodation chamber 201 of the guiding carrier 20. Since the air pump 22 and the supporting substrate 4 enclose the top side and the bottom side of the frame structure of the guiding carrier 20 respectively, the introduction opening 202, the accommodation chamber 201 and the plural discharge grooves 203 collaboratively define a sealed air passage. The air passage guides and collects the introduced air. Therefore, the introduced air flows through the electronic component 3 and removes the heat therefrom. It is noted that numerous modifications and alterations may be made while retaining the teachings of the invention.

In some embodiments, the guiding carrier 20 further comprises a receiving part (not shown). The receiving part is a recess that is arranged around the introduction opening 202 where the air pump 22 is configured on, and is concavely formed on the first surface 20a of the guiding carrier 20. The air pump 22 is coupled with the receiving part and seals the edge of the introduction opening 202. Since the air pump 22 is coupled with the receiving part in a level lower than the first surface 20a, the overall height of the air-cooling heat dissipation device 2 is reduced. In other words, the air-cooling heat dissipation device 2 according to this embodiment can have a thinner profile.

Please refer to FIG. 2B again. The air pump 22 is operable to drive and introduce exterior ambient air through the introduction opening 202 into the accommodation chamber 201, and an air flow is thereby generated that removes heat from the electronic component 3 within the accommodation chamber 201. Meanwhile, the air flow pushes the initial air in the accommodation chamber 201 to flow quickly, which is beneficial to discharge the heated air through the discharge grooves 203 of the guiding carrier 20 to the exterior of the air-cooling heat dissipation device 2. During operation of the air pump 22, external air is continuously fed into the accommodation chamber 201, and the heat from the electronic component 3 is thereby continuously removed by the introduced air. Consequently, the heat dissipating efficiency is enhanced, the performance of the electronic component 3 is stabilized, and the life span of the electronic component 3 are extended.

FIG. 4 is a schematic cross-sectional view illustrating an air-cooling heat dissipation device according to a second embodiment of the present invention. Components corresponding to those of the first embodiment are designated by identical numeral references, and detailed descriptions thereof are omitted. In comparison with the air-cooling heat dissipation device 2 of FIG. 2B, the air-cooling heat dissipation device 2a of this embodiment further comprises a heat sink 25. The heat sink 25 is disposed on the first surface 3a of the electronic component 3 and positioned in the accommodation chamber 201. The heat sink 25 comprises a base plate 251 and plural fins 252. The base plate 251 is attached on the first surface 3a of the electronic component 3, and the plural fins 252 are perpendicularly mounted on the base plate 251. The heat generated by the electronic component 3 is transferred through the heat sink 25 and dissipated in the accommodation chamber 201. Since the heat sink 25 provides larger surface area in contact with the air, the heat dissipating efficacy is consequently enhanced.

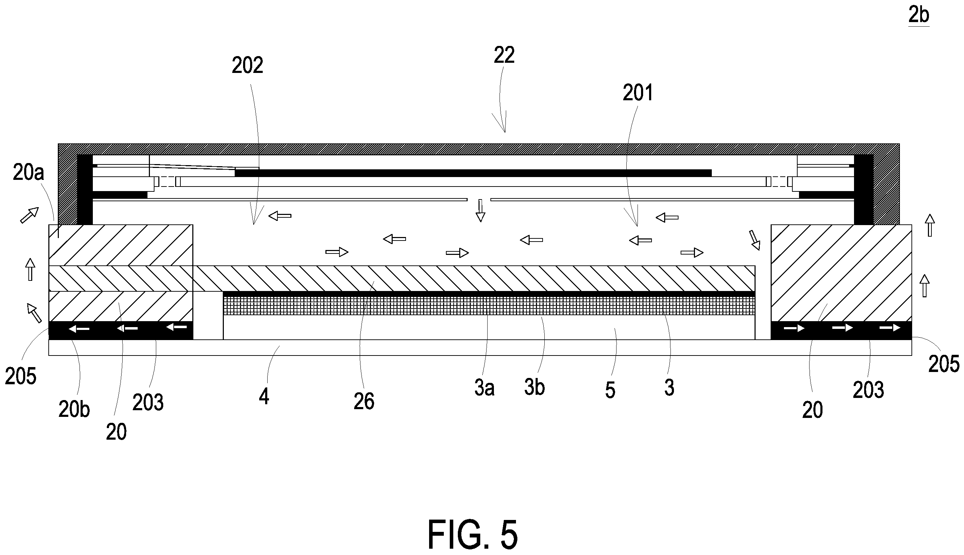

FIG. 5 is a schematic cross-sectional view illustrating an air-cooling heat dissipation device according to a third embodiment of the present invention. Components corresponding to those of the first embodiment are designated by identical numeral references, and detailed descriptions thereof are omitted. In comparison with the air-cooling heat dissipation device 2 of FIG. 2B, the air-cooling heat dissipation device 2b of this embodiment further comprises a heat pipe 26. The heat pipe 26 is attached on a surface of the electronic component 3 and accommodated within the accommodation chamber 201. The heat pipe 26 is made of a material having good thermal conductivity, and is attached on the first surface 3a of the electronic component 3. In some embodiments, a first end of the heat pipe 26 extends to the outside of the guiding carrier 20 through the lateral surface 204, whereas a second end of the heat pipe 26 is contacted with the surface of the electronic component 3. Therefore, the heat from the electronic component 3 can be transferred to the external surroundings through the heat pipe 26. Moreover, the heat pipe 26 itself works as a heat exchanger in the accommodation chamber 201 that speeds up the process of heat dissipation. Consequently, the heat dissipating efficiency is further enhanced.

FIG. 6A is a schematic exploded view illustrating an air pump used in the air-cooling heat dissipation device of the present invention and taken along the rear side. FIG. 6B is a schematic exploded view illustrating the air pump of FIG. 6A and taken along the front side. As shown in FIGS. 6A and 6B, the air pump 21 is a piezoelectric air pump for driving the gas. In this embodiment, the air pump 21 comprises a resonance plate 221, a piezoelectric actuator 222 and a covering member 226. The resonance plate 221 comprises a central aperture 221a aligned with the introduction opening 202 of the guiding carrier 20. The piezoelectric actuator 222 comprises a suspension plate 2221, an outer frame 2222, a piezoelectric element 2223 and at least one bracket 2224. In response to an applied voltage, the piezoelectric actuator 222 drives the air pump 22 to operate.

The covering member 226 comprises a sidewall 2261, a bottom plate 2262 and an opening 2263. The sidewall 2261 is protruded from the edges of the bottom plate 2262. Moreover, an accommodation space 226a is defined by the sidewall 2261 and the bottom plate 2262 collaboratively. The resonance plate 221 and the piezoelectric actuator 222 are accommodated within the accommodation space 226a. The opening 2263 is formed in the sidewall 2261. The conducting pin 2222a of the outer frame 2222 is protruded out of the covering member 226 through the opening 2263 so as to be electrically connected with an external circuit (not shown).

In this embodiment, the suspension plate 2221 comprises a middle portion 2221c and a periphery portion 2221d. When the piezoelectric element 2223 is subjected to the curvy vibration in response to an applied voltage, the suspension plate 2221 is subjected to the curvy vibration from the middle portion 2221c to the periphery portion 2221d. The outer frame 2222 is arranged around the suspension plate 2221 and comprises at least one conducting pin 2222a. The conducting pin 2222a is protruded outwardly from the outer frame 2222 so as to be electrically connected with an external circuit (not shown). The length of a side of the piezoelectric element 2223 is less than or equal to the length of a side of the suspension plate 2221. The piezoelectric element 2223 is attached on a second surface 2221b of the suspension plate 2221. When the piezoelectric element 2223 is subjected to deformation in response to an applied voltage, the suspension plate 2221 is subjected to a curvy vibration. The at least one bracket 2224 is arranged between the suspension plate 2221 and the outer frame 2222. The two ends of the bracket 2224 are connected with the suspension plate 2221 and the outer frame 2222, respectively. Consequently, the bracket 2224 can elastically support the suspension plate 2221.

The air pump 21 further comprises a first insulation plate 223, a conducting plate 224 and a second insulation plate 225. The first insulation plate 223 is located over the conducting plate 224. The second insulation plate 225 is located under the conducting plate 224. The shapes of the first insulation plate 223 and the second insulation plate 225 substantially match the shape of the outer frame 2222 of the piezoelectric actuator 222. The first insulation plate 223 and the second insulation plate 225 are made of an insulating material (e.g. a plastic material) for providing insulating efficacy. The conducting plate 224 is made of an electrically conductive material (e.g. a metallic material) for providing electrically conducting efficacy. The shape of the conducting plate 224 substantially matches the shape of the outer frame 2222 of the piezoelectric actuator 222. Moreover, the conducting plate 224 has a conducting pin 224a for being electrically connected with an external circuit (not shown). Similarly, the conducting pin 224a is protruded out of the covering member 226 through the opening 2263 for being electrically connected with an external circuit (not shown).

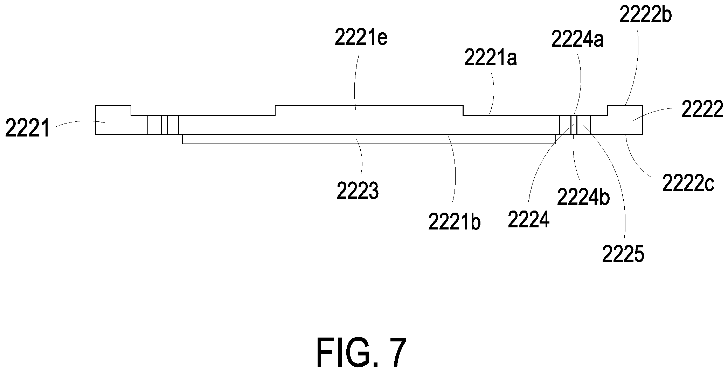

FIG. 7 is a schematic cross-sectional view illustrating a piezoelectric actuator of the air pump as shown in FIGS. 6A and 6B. In this embodiment, the suspension plate 2221 is a stepped structure. That is, the suspension plate 2221 comprises a bulge 2221e. The bulge 2221e is formed on the first surface 2221a of the suspension plate 2221 and located at the middle portion 2221c. For example, the bulge 2221e is a circular convex structure or a cylinder, but not limited thereto. In some embodiments, the suspension plate 2221 is a square plate structure with two flat surfaces.

Please refer to FIG. 7 again. A top surface of the bulge 2221e of the suspension plate 2221 is coplanar with a first surface 2222b of the outer frame 2222, and the first surface 2221a of the suspension plate 2221 is coplanar with a first surface 2224a of the bracket 2224. Moreover, the bulge 2221e of the suspension plate 2221 (or the first surface 2222b of the outer frame 2222) has a specified thickness with respect to the first surface 2221a of the suspension plate 2221 (or the first surface 2224a of the bracket 2224). A second surface 2221b of the suspension plate 2221, a second surface 2222c of the outer frame 2222 and a second surface 2224 of the bracket 2224 are coplanar with each other. The piezoelectric element 2223 is attached on the second surface 2221b of the suspension plate 2221. In some other embodiments, the suspension plate 2221 is a square plate structure with two flat surfaces. That is, the structure of the suspension plate 2221 may be varied according to the practical requirements. In this embodiment, the suspension plate 2221, the outer frame 2222 and the at least bracket 2224 are integrally formed and produced by using a metal plate (e.g., a stainless steel plate). Moreover, at least one vacant space 2225 is formed between the suspension plate 2221, the outer frame 2222 and the bracket 2224 for allowing the gas to go through.

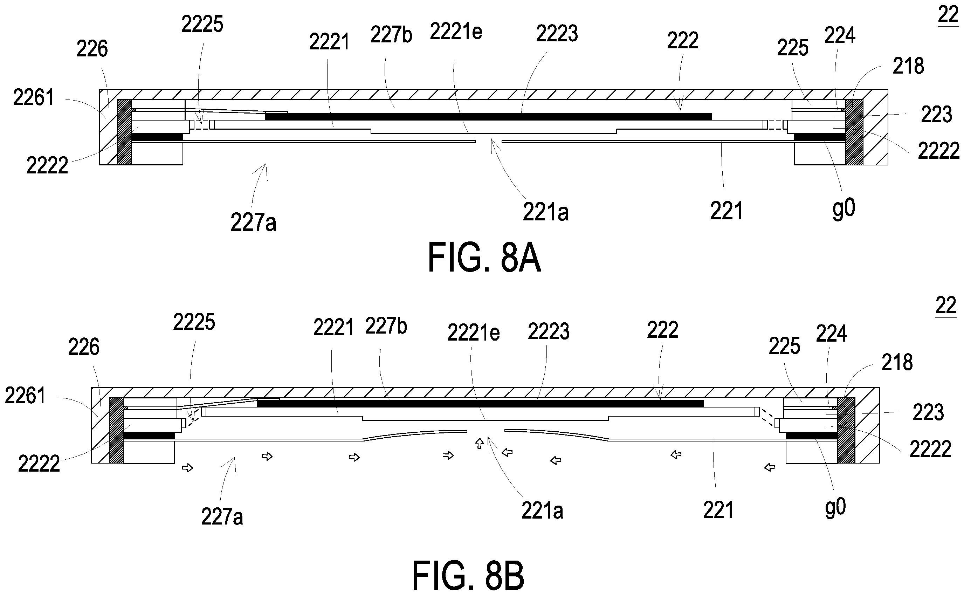

The operations of the air pump 22 will be described as follows. FIGS. 8A to 8D schematically illustrate the actions of the air pump according to the embodiment of the present invention. Please refer to FIG. 8A. After the covering member 226, the second insulation plate 225, the conducting plate 224, the first insulation plate 223, the piezoelectric actuator 222 and the resonance plate 221 of the air pump 22 are stacked on each other sequentially, the air pump 22 is assembled. After the peripheries of the piezoelectric actuator 222, the first insulation plate 223, the conducting plate 224 and the second insulation plate 225 are coated with glue, a glue layer 218 is formed and fills the accommodation space 226a of the covering member 226. Consequently, the air pump 22 is assembled. There is a gap g0 between the resonance plate 221 and the piezoelectric actuator 222. The convergence chamber 227a is defined by the resonance plate 221 and the sidewall 2261 of the covering member 216 collaboratively. The first chamber 227b is formed between the resonance plate 221 and the bottom plate 2262 of covering member 226. Meanwhile, the air pump 22 is not activated.

Please refer to FIG. 8B. When the piezoelectric actuator 222 of the air pump 22 is actuated and vibrates upwardly, the ambient gas is introduced into the air pump 22 through the opening 2263 (shown in FIG. 6A) of the covering member 226, and is converged to the convergence chamber 227a. Then, the gas is transferred to the first chamber 227b through the central aperture 221a of the resonance plate 221. Due to the resonance effect of the suspension plate 2221, the resonance plate 221 also vibrates in a reciprocating manner. FIG. 8B shows that the resonance plate 221 is subjected to an upward deformation during reciprocate vibration, the portion of the resonance plate 221 around the central aperture 221a is protruded upwardly.

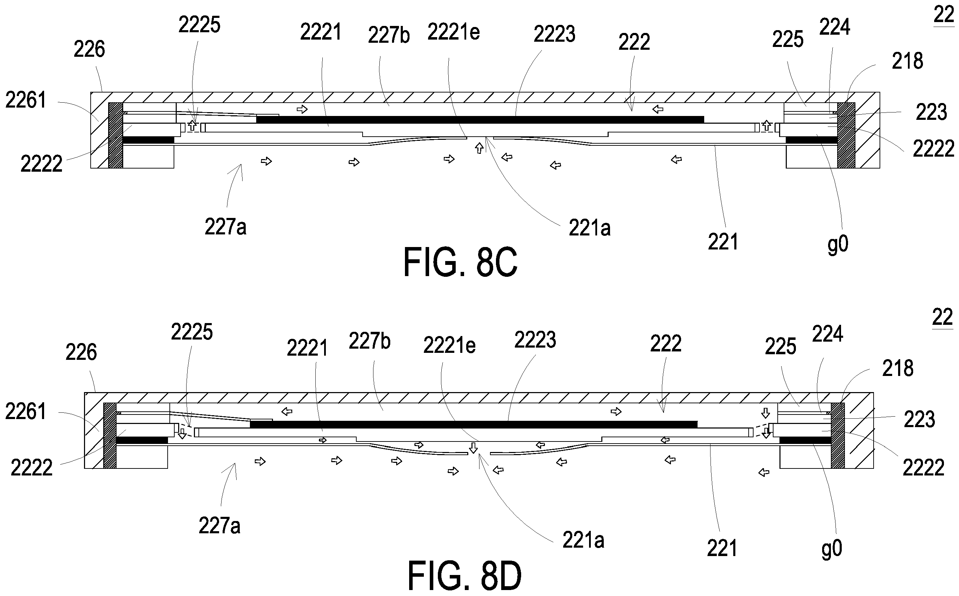

Please refer to FIG. 8C. The piezoelectric actuator 223 is vibrating downwardly and has returned to its original position. Meanwhile, the bulge 2221e of the suspension plate 2221 of the piezoelectric actuator 222 is moving towards the resonance plate 221, so that the lower portion of the first chamber 227b, which is in between the suspension plate 2221 and the resonance plate 221, is shrunken. Since the volume of the lower portion of the first chamber 227b is shrunken, the gas therein is pushed toward peripheral regions of the lower portion of the first chamber 227b, and is transferred upwardly through the vacant space 2225 of the piezoelectric actuator 222. Consequently, the gas in the air pump 22 is transferred to the upper portion of the first chamber 217b and temporarily stored therein, wherein the upper portion of the first chamber 217b is in between the covering member 226 and the suspension plate 2221. From the above discussions, when the resonance plate 221 is vibrating along the vertical direction in the reciprocating manner, the gap g0 between the resonance plate 221 and the piezoelectric actuator 222 is helpful to increase the amplitude of the resonance plate 221. That is, the proper gap g0 between the resonance plate 221 and the piezoelectric actuator 222 allows a maximum amplitude of vibration of the resonance plate 221.

Please refer to FIG. 8D. The piezoelectric actuator 222 is further vibrating downwardly. Due to the resonance effect of the piezoelectric actuator 222, the resonance plate 221 is also vibrating downwardly. Due to the downward deformation of the resonance plate 221, the volume of the lower portion of the first chamber 227b is shrunken. Consequently, the gas in the upper portion of the first chamber 227b is pushed toward peripheral regions of the upper portion of the first chamber 227b. Then, the gas is transferred downwardly through the vacant space 2225 of the piezoelectric actuator 222, and transferred through the central aperture 221a of the resonance plate 221. Consequently, an air flow is discharged from the introduction opening 23 of the guiding carrier 20 and transferred toward the thermal conduction plate 4 so as to cool the electronic component 3.

Finally, the resonance plate 221 is returned to its original position, as shown in FIG. 8A. The processes of FIGS. 8A to 8D are repeatedly done. Consequently, the gas is continuously introduced into the convergence chamber 227a through the opening 2263 of the covering member 226, and transferred to the first chamber 227b. Then, the gas is transferred from the first chamber 227b to the convergence chamber 227a, and continuously fed into the introduction opening 23. Consequently, the gas can be transferred in a steady way. When the air pump 22 is operated, the gas is sequentially transferred through the opening 2263 of the covering member 226, the convergence chamber 227a, the first chamber 227b, the convergence chamber 227a and the introduction opening 23. Therefore, by utilizing the single covering member 226 of the air pump 22 and utilizing the opening 2263 of the covering member 226, the components of the air pump 22 can be reduced and the assembling process can be simplified.

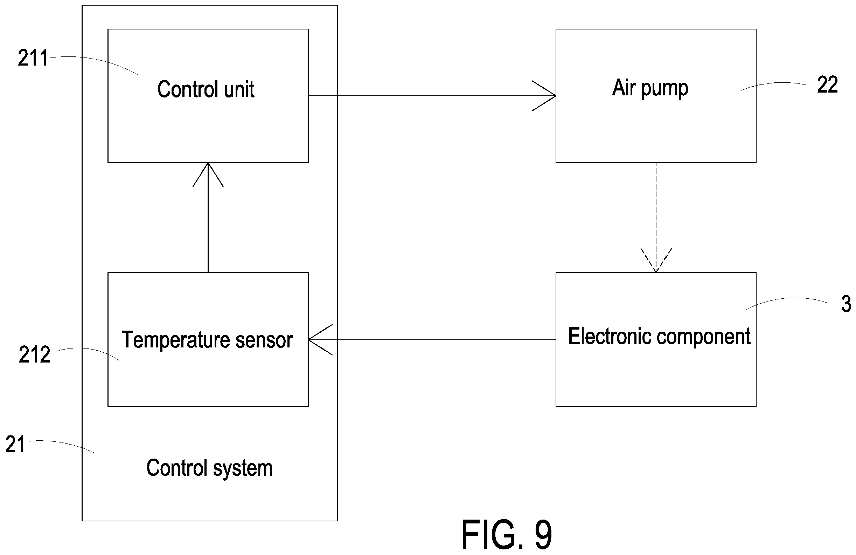

FIG. 9 is a schematic cross-sectional view illustrating an air-cooling heat dissipation device according to a third embodiment of the present invention. In this embodiment, the air-cooling heat dissipation device 2 further provides a temperature controlling function. The air-cooling heat dissipation device 2 further comprises a control system 21. The control system 21 comprises a control unit 211 and a temperature sensor 212. The control unit 211 is electrically connected with the air pump 22 to control the operation of the air pump 22. In an embodiment, the temperature sensor 212 is disposed within accommodation chamber 201 of the guiding carrier 20 and located near the electronic component 3 for sensing the temperature near the electronic component 3. Alternatively, the temperature sensor 212 is attached on the electronic component 3 for sensing the temperature of the electronic component 3. The temperature sensor 212 is electrically connected with the control unit 211. After detecting the temperature of the electronic component 3, the temperature sensor 212 accordingly transmits a detecting signal to the control unit 211. After receiving the detecting signal, the control unit 211 determines whether the temperature of the electronic component 3 is higher than or equal to a threshold value. If the control unit 211 determines that the temperature of the electronic component 3 is higher than or equal to the threshold value, the control unit 211 issues an enabling signal to the air pump 22 to enable the air pump 22. When the air pump 22 is enabled, the gas is driven to cool the electronic component 3. Consequently, the heat of the electronic component 3 is dissipated away and the temperature of the electronic component 3 drops. Oppositely, if the control unit 211 determines that the temperature of the electronic component 3 is lower than the threshold value, the control unit 211 issues a disabling signal to the air pump 22 to disable the air pump 22, so that unnecessary operation of the air pump 22 is prevented, which prolongs the life span of the air pump 22 and saves power consumption. That is, in case that the temperature of the electronic component 3 is too high, the control system 21 controls the air pump 22 to cool the electronic component 3; oppositely, in case that the temperature of the electronic component 3 has been dropped, the control system 21 disables the air pump 22. Since the electronic component 3 is operated at a suitable temperature, the performance stability of the electronic component 3 is increased.

From the above descriptions, the present invention provides an air-cooling heat dissipation device. The air-cooling heat dissipation device is applied to various electronic devices to remove heat from electronic components of the electronic devices. Consequently, the heat dissipating efficiency is enhanced, the noise is reduced, the performance of the electronic components of the electronic device is stabilized, and the life spans of the electronic components are extended. Moreover, the operations of an air pump are controlled according to the temperature changes of the electronic components of the electronic device. Consequently, the heat dissipating efficiency is enhanced, and the life span of the air pump is extended.

## Claims

1. An air-cooling heat dissipation device (2) for removing heat from an electronic component (3), the air-cooling heat dissipation device (2) comprising:
an air pump (22) comprising:
a resonance plate (221) having a central aperture (221a); and
a piezoelectric actuator (222) aligned with the resonance plate (221),
**characterized in that** the air-cooling heat dissipation device (2) further comprises:
a guiding carrier (20) comprising a first surface (20a) and an opposing second surface (20b), an accommodation chamber (201), an introduction opening (202) and plural discharge grooves (203), wherein the accommodation chamber (201) runs through the first surface (20a) and the second surface (20b), the introduction opening (202) is formed in the first surface (20a) and in communication with the accommodation chamber (201), the plural discharge grooves (203) are formed in the second surface (20b) and in communication with the accommodation chamber (201), and the electronic component (3) is accommodated within the accommodation chamber (201); and
the air pump (22) further comprising:
a covering member (226) having a sidewall (2261), a bottom plate (2262) and an opening (2263), wherein the sidewall (2261) is protruding from the edge of the bottom plate (2262), an accommodation space (226a) is defined by the bottom plate (2262) and the sidewall (2261) collaboratively, the resonance plate (221) and the piezoelectric actuator (222) are disposed within the accommodation space (226a), and the opening (2263) is formed on the sidewall (2261), wherein a first chamber (227b) is formed between the resonance plate (221) and the bottom plate (2262) of covering member (226), and a convergence chamber (227a) is defined by the resonance plate (221) and the sidewall (2261) of the covering member (226) collaboratively;
wherein the covering member (226), the piezoelectric actuator (222) and the resonance plate (221) are stacked sequentially and fixed on the guiding carrier (20) to seal the introduction opening (202), wherein when the piezoelectric actuator (222) is enabled to perform a gas-collection operation, a gas is introduced into the air pump (22) through the opening (2263) of the covering member (226) and converged to the convergence chamber (227a), and then the gas is transferred to and temporarily stored in the first chamber (227b) through the central aperture (221a) of the resonance plate (221), wherein when the piezoelectric actuator (222) is enabled to perform an gas-releasing operation, the gas flows from the first chamber (227b) to the convergence chamber (227a) through the central aperture (221a) of the resonance plate (221) and then the gas is introduced into the accommodation chamber (201) through the introduction opening (202) so that an air flow is generated to exchange heat with the electronic component (3), after which the heated air flow is discharged through the plural discharge grooves (203).

2. The air-cooling heat dissipation device (2) according to claim 1, wherein the air-cooling heat dissipation device (2) further comprises a supporting substrate (4) connected to the second surface (20b) of the guiding carrier (20), and the electronic component (3) is disposed on the supporting substrate (4).

3. The air-cooling heat dissipation device (2) according to claim 2, wherein the guiding carrier (20) further comprises a receiving part, wherein the receiving part is a recess concavely formed in the first surface (20a) of the guiding carrier (20) and arranged around the introduction opening (202), and the air pump (22) is coupled with the receiving part and seals the edge of the introduction opening (202).

4. The air-cooling heat dissipation device (2) according to one of the preceding claims, wherein the guiding carrier (20) has a frame structure.

5. The air-cooling heat dissipation device (2) according to one of the preceding claims, wherein the piezoelectric actuator (222) comprises:
a suspension plate (2221) having a first surface (2221a) and an opposing second surface (2221b), wherein the suspension plate (2221) is permitted to undergo a curvy vibration;
an outer frame (2222) arranged around the suspension plate (2221);
at least one bracket (2224) connected between the suspension plate (2221) and the outer frame (2222) for elastically supporting the suspension plate (2221); and
a piezoelectric element (2223) having a side, wherein a length of the side of the piezoelectric element (2223) is smaller than or equal to a length of a side of the suspension plate (2221), and the piezoelectric element (2223) is attached on the second surface (2221b) of the suspension plate (2221), wherein when a voltage is applied to the piezoelectric element (2223), the suspension plate (2221) is driven to undergo the curvy vibration.

6. The air-cooling heat dissipation device (2) according to claim 5, the suspension plate (2221) is a square suspension plate with a bulge (2221e) formed thereon.

7. The air-cooling heat dissipation device (2) according to claim 5 or 6, wherein the air pump (22) further comprises a conducting plate (224), a first insulation plate (223) and a second insulation plate (225), wherein the resonance plate (221), the piezoelectric actuator (222), the first insulation plate (223), the conducting plate (224) and the second insulation plate (225) are stacked on each other sequentially.

8. The air-cooling heat dissipation device (2) according to claim 7, wherein the outer frame (2222) of the piezoelectric actuator (222) comprises a first conducting pin (2222a), the conducting plate (224) comprises a second conducting pin (224a), and the opening (2263) of the covering member (226) is formed on the sidewall (2261) of the covering member (226), wherein the first conducting pin (2222a) and the second conducting pin (224a) are protruded out of the opening (2263) of the covering member (226) so as to be electrically connected with an external circuit.

9. The air-cooling heat dissipation device (2) according to one of the preceding claims, further comprising a control system (21), wherein the control system (21) comprises:
a control unit (211) electrically connected with the air pump (22) for controlling operations of the air pump (22); and
a temperature sensor (212) electrically connected with the control unit (211) and located near the electronic component (3), wherein the temperature sensor (212) detects a temperature of the electronic component (3) and generates a corresponding detecting signal to the control unit (211), wherein the control unit (211) obtains the temperature of the electronic component (3) according to the detecting signal, wherein if the control unit (3) determines the temperature of the electronic component (3) is higher than or equal to a threshold value, the control unit (211) enables the air pump (22) to generate the air flow, wherein if the control unit (22) determines the temperature of the electronic component (3) is lower than the threshold value, the control unit (211) disables the air pump (22).

10. The air-cooling heat dissipation device (2) according to one of the preceding claims, further comprising:
a heat sink (25) attached on the electronic component (3) and disposed within the accommodation chamber (201).

11. The air-cooling heat dissipation device (2) according to one of the preceding claims, further comprising
a heat pipe (26) attached on a surface of the electronic component (3) and disposed within the accommodation chamber (201).

## Patentansprüche

1. Luftkühlende Wärmeableitungsvorrichtung (2) zum Entfernen von Wärme aus einem elektronischen Bauteil (3), wobei die luftkühlende Wärmeableitungsvorrichtung (2) umfasst:
eine Luftpumpe (22), die umfasst:
eine Resonanzplatte (221) mit einer zentralen Öffnung (221a); und
ein piezoelektrisches Stellglied (222), das auf die Resonanzplatte (221) ausgerichtet ist,
**dadurch gekennzeichnet, dass** die luftkühlende Wärmeableitungsvorrichtung (2) ferner umfasst:
einen Führungsträger (20), der eine erste Fläche (20a) und eine gegenüberliegende zweite Fläche (20b), eine Aufnahmekammer (201), eine Einführungsöffnung (202) und mehrere Auslaufnuten (203) umfasst, wobei die Aufnahmekammer (201) durch die erste Fläche (20a) und die zweite Fläche (20b) verläuft, die Einführungsöffnung (202) in der ersten Fläche (20a) und in Verbindung mit der Aufnahmekammer (201) ausgebildet ist, die mehreren Auslaufnuten (203) in der zweiten Fläche (20b) und in Verbindung mit der Aufnahmekammer (201) ausgebildet sind, und das elektronische Bauteil (3) innerhalb der Aufnahmekammer (201) angeordnet ist; und
wobei die Luftpumpe (22) ferner umfasst:
ein Abdeckelement (226) mit einer Seitenwand (2261), einer Bodenplatte (2262) und einer Öffnung (2263), wobei die Seitenwand (2261) vom Rand der Bodenplatte (2262) vorsteht, ein Aufnahmebereich (226a) durch die Bodenplatte (2262) und die Seitenwand (2261) gemeinsam definiert ist, die Resonanzplatte (221) und das piezoelektrische Stellglied (222) innerhalb des Aufnahmebereichs (226a) angeordnet sind, und die Öffnung (2263) an der Seitenwand (2261) ausgebildet ist, wobei eine erste Kammer (227b) zwischen der Resonanzplatte (221) und der Bodenplatte (2262) des Abdeckelements (226) ausgebildet ist, und eine Konvergenzkammer (227a) durch die Resonanzplatte (221) und die Seitenwand (2261) des Abdeckelements (226) gemeinsam definiert ist;
wobei das Abdeckelement (226), das piezoelektrische Stellglied (222) und die Resonanzplatte (221) nacheinander gestapelt und auf dem Führungsträger (20) befestigt sind, um die Einführungsöffnung (202) abzudichten, wobei, wenn das piezoelektrische Stellglied (222) aktiviert ist, einen Gassammelvorgang durchzuführen, ein Gas durch die Öffnung (2263) des Abdeckelements (226) in die Luftpumpe (22) eingeleitet und in die Konvergenzkammer (227a) konvergiert wird, und dann das Gas durch die zentrale Öffnung (221a) der Resonanzplatte (221) in die erste Kammer (227b) übertragen und dort zwischengespeichert wird, wobei, wenn das piezoelektrische Stellglied (222) aktiviert ist, einen Gasfreisetzungsvorgang durchzuführen, das Gas von der ersten Kammer (227b) zu der Konvergenzkammer (227a) durch die zentrale Öffnung (221a) der Resonanzplatte (221) strömt und dann das Gas durch die Einführungsöffnung (202) in die Aufnahmekammer (201) eingeführt wird, so dass ein Luftstrom erzeugt wird, um Wärme mit dem elektronischen Bauteil (3) auszutauschen, wonach der erwärmte Luftstrom durch die mehreren Auslassnuten (203) abgegeben wird.

2. Luftkühlende Wärmeableitungsvorrichtung (2) nach Anspruch 1, wobei die luftkühlende Wärmeableitungsvorrichtung (2) ferner ein mit der zweiten Fläche (20b) des Führungsträgers (20) verbundenes Trägersubstrat (4) umfasst und das elektronische Bauteil (3) auf dem Trägersubstrat (4) angeordnet ist.

3. Luftkühlende Wärmeableitvorrichtung (2) nach Anspruch 2, wobei der Führungsträger (20) ferner einen Aufnahmeteil umfasst, wobei der Aufnahmeteil eine in der ersten Fläche (20a) des Führungsträgers (20) konkav ausgebildete und um die Einführungsöffnung (202) angeordnete Ausnehmung ist und die Luftpumpe (22) mit dem Aufnahmeteil gekoppelt ist und den Rand der Einführungsöffnung (202) abdichtet.

4. Luftkühlende Wärmeableitungsvorrichtung (2) nach einem der vorhergehenden Ansprüche, wobei der Führungsträger (20) eine Rahmenstruktur aufweist.

5. Luftkühlende Wärmeableitungsvorrichtung (2) nach einem der vorhergehenden Ansprüche, wobei das piezoelektrische Stellglied (222) umfasst:
eine Suspensionsplatte (2221) mit einer ersten Fläche (2221a) und einer gegenüberliegenden zweiten Fläche (2221b), wobei die Suspensionsplatte (2221) einer kurvenreichen Vibration ausgesetzt werden kann;
einen Außenrahmen (2222), der um die Suspensionsplatte (2221) herum angeordnet ist;
mindestens eine Halterung (2224), die zwischen der Suspensionsplatte (2221) und dem Außenrahmen (2222) verbunden ist, um die Suspensionsplatte (2221) elastisch zu stützen; und
ein piezoelektrisches Element (2223) mit einer Seite, wobei eine Länge der Seite des piezoelektrischen Elements (2223) kleiner oder gleich einer Länge einer Seite der Suspensionsplatte (2221) ist, und das piezoelektrische Element (2223) auf der zweiten Fläche (2221b) der Suspensionsplatte (2221) befestigt ist, wobei, wenn eine Spannung an das piezoelektrische Element (2223) angelegt wird, die Suspensionsplatte (2221) angetrieben wird, um sich der kurvenreichen Vibration zu unterziehen.

6. Luftkühlende Wärmeableitungsvorrichtung (2) nach Anspruch 5, wobei die Suspensionsplatte (2221) eine quadratische Suspensionsplatte mit einer darauf ausgebildeten Wölbung (2221e) ist.

7. Luftkühlende Wärmeableitvorrichtung (2) nach Anspruch 5 oder 6, wobei die Luftpumpe (22) ferner eine leitende Platte (224), eine erste Isolierplatte (223) und eine zweite Isolierplatte (225) umfasst, wobei die Resonanzplatte (221), das piezoelektrische Stellglied (222), die erste Isolierplatte (223), die leitende Platte (224) und die zweite Isolierplatte (225) nacheinander aufeinander gestapelt sind.

8. Luftkühlende Wärmeableitungsvorrichtung (2) nach Anspruch 7, wobei der Außenrahmen (2222) des piezoelektrischen Stellglieds (222) einen ersten leitenden Stift (2222a) umfasst, die leitende Platte (224) einen zweiten leitenden Stift (224a), und die Öffnung (2263) des Abdeckelements (2263) an der Seitenwand (2261) des Abdeckelements (226) ausgebildet ist, wobei der erste leitende Stift (2222a) und der zweite leitende Stift (224a) aus der Öffnung (2263) des Abdeckelements (226) herausragt, um elektrisch mit einer externen Schaltung verbunden zu sein.

9. Luftkühlende Wärmeableitungsvorrichtung (2) nach einem der vorhergehenden Ansprüche, ferner umfassend ein Steuerungssystem (21), wobei das Steuerungssystem (21) umfasst:
eine Steuerungseinheit (211), die elektrisch mit der Luftpumpe (22) verbunden ist, um den Betrieb der Luftpumpe (22) zu steuern; und
einen Temperatursensor (212), der elektrisch mit der Steuerungseinheit (211) verbunden und in der Nähe der elektronischen Bauteil (3) angeordnet ist, wobei der Temperatursensor (212) eine Temperatur des elektronischen Bauteils (3) erfasst und ein entsprechendes Detektionssignal für die Steuerungseinheit (211) erzeugt,
wobei die Steuerungseinheit (211) die Temperatur des elektronischen Bauteil (3) gemäß dem Detektionssignal erhält, wobei, wenn die Steuerungseinheit (3) bestimmt, dass die Temperatur des elektronischen Bauteils (3) höher oder gleich einem Schwellenwert ist, die Steuerungseinheit (211) der Luftpumpe (22) ermöglicht, den Luftstrom zu erzeugen, wobei, wenn die Steuerungseinheit (22) bestimmt, dass die Temperatur des elektronischen Bauteils (3) niedriger als der Schwellenwert ist, die Steuerungseinheit (211) die Luftpumpe (22) deaktiviert.

10. Luftkühlende Wärmeableitungsvorrichtung (2) nach einem der vorhergehenden Ansprüche, ferner umfassend:
einen Kühlkörper (25), der an dem elektronischen Bauteil (3) befestigt und innerhalb der Aufnahmekammer (201) angeordnet ist.

11. Luftkühlende Wärmeableitungsvorrichtung (2) nach einem der vorhergehenden Ansprüche, ferner umfassend
ein Wärmerohr (26), das auf einer Fläche des elektronischen Bauteils (3) befestigt und innerhalb der Aufnahmekammer (201) angeordnet ist.

## Revendications

1. Un dispositif de dissipation de chaleur à refroidissement par air (2) pour évacuer la chaleur d'un composant électronique (3), le dispositif de dissipation de chaleur à refroidissement par air (2) comprenant:
une pompe à air (22) comprenant :
une plaque de résonance (221) ayant une ouverture centrale (221a) ; et
un actionneur piézoélectrique (222) aligné avec la plaque de résonance (221),
**caractérisé en ce que** le dispositif de
un support de guidage (20) comprenant une première surface (20a) et une seconde surface opposée (20b), une chambre de logement (201), une ouverture d'introduction (202) et plusieurs rainures d'évacuation (203), dans lequel la chambre de logement (201) traverse la première surface (20a) et la seconde surface (20b), l'ouverture d'introduction (202) étant formée dans la première surface (20a) et en communication avec la chambre de logement (201), la pluralité de rainures de décharge (203) sont formées dans la seconde surface (20b) et en communication avec la chambre de logement (201)), et le composant électronique (3) est logé dans la chambre de logement (201); et
la pompe à air (22) comprenant en outre:
un élément de couverture (226) ayant une paroi latérale (2261), une plaque inférieure (2262) et une ouverture (2263), dans lequel la paroi latérale (2261) fait saillie à partir du bord de la plaque inférieure (2262), un espace de logement (226a) étant défini en collaboration par la plaque inférieure (2262) et par la paroi latérale (2261), la plaque de résonance (221) et l'actionneur piézoélectrique (222) sont disposés dans l'espace de logement (226a), et l'ouverture (2263) est formée sur la paroi latérale (2261), dans lequel une première chambre (227b) est formée entre la plaque de résonance (221) et la plaque inférieure (2262) de l'élément de couverture (226), et une chambre de convergence (227a) est définie par la plaque de résonance (221) et la paroi latérale (2261) de l'élément de couverture (226) en collaboration;
dans lequel l'élément de couverture (226), l'actionneur piézoélectrique (222) et la plaque de résonance (221) sont empilés séquentiellement et fixés sur le support de guidage (20) pour sceller l'ouverture d'introduction (202), dans lequel lorsque l'actionneur piézoélectrique (222) est activé pour effectuer une opération de collecte de gaz au travers l'ouverture (2263) de l'élément de couverture (226) et converge vers la chambre de convergence (227a), et puis le gaz est transféré et stocké temporairement dans la première chambre (227b) au travers l'ouverture centrale (221a) de la plaque de résonance (221), dans lequel lorsque l'actionneur piézoélectrique (222) est activé pour effectuer une opération de libération de gaz, le gaz s'écoule depuis la première chambre (227b) jusqu'à la chambre de convergence (227a) à travers l'ouverture centrale (221a) de la plaque de résonance (221), puis le gaz est introduit dans la chambre de logement (201) à travers l'ouverture d'introduction (202) de sorte qu'un écoulement d'air est généré pour échanger de la chaleur avec le composant électronique (3), à la suite de quoi le flux d'air chauffé est évacué à travers les multiples rainures d'évacuation (203).

2. Le dispositif de dissipation de chaleur à refroidissement par air (2) selon la revendication 1, dans lequel le dispositif de dissipation de chaleur à refroidissement par air (2) comprend en outre un substrat de support (4) connecté à la deuxième surface (20b) du support de guidage (20), et le composant électronique (3) est disposé sur le substrat de support (4).

3. Le dispositif de dissipation de chaleur à refroidissement par air (2) selon la revendication 2, dans lequel le support de guidage (20) comprend en outre une partie de réception, dans lequel la partie de réception est un évidement formé de manière concave dans la première surface (20a) du support de guidage (20) et disposée autour de l'ouverture d'introduction (202), et la pompe à air (22) est couplée à la partie de réception et ferme hermétiquement le bord de l'ouverture d'introduction (202).

4. Le dispositif de dissipation de chaleur par refroidissement à l'air (2) selon l'une des revendications précédentes, dans lequel le support de guidage (20) présente la structure d'un cadre.

5. Le dispositif de dissipation de chaleur à refroidissement par air (2) selon l'une des revendications précédentes, dans lequel l'actionneur piézoélectrique (222) comprend:
une plaque de suspension (2221) ayant une première surface (2221a) et une seconde surface opposée (2221b), dans laquelle la plaque de suspension (2221) peut subir une vibration incurvée;
un cadre externe (2222) disposé autour de la plaque de suspension (2221);
au moins un support (2224) connecté entre la plaque de suspension (2221) et le cadre externe (2222) pour supporter de manière élastique la plaque de suspension (2221); et
un élément piézoélectrique (2223) ayant un côté, dans lequel la longueur du côté de l'élément piézoélectrique (2223) est inférieure ou égale à la longueur d'un côté de la plaque de suspension (2221), et l'élément piézoélectrique (2223) est fixé sur la deuxième surface (2221b) de la plaque de suspension (2221), dans lequel lorsqu'une tension est appliquée à l'élément piézoélectrique (2223), la plaque de suspension (2221) est entraînée pour subir la vibration incurvée.

6. Le dispositif de dissipation de chaleur à refroidissement par air (2) selon la revendication 5, dans lequel la plaque de suspension (2221) est une plaque de suspension carrée sur laquelle est formé un renflement (2221e).

7. Le dispositif de dissipation de chaleur à refroidissement par air (2) selon la revendication 5 ou 6, dans lequel la pompe à air (22) comprend en outre une plaque conductrice (224), une première plaque isolante (223) et une seconde plaque isolante (225), dans lequel la plaque de résonance (221), l'actionneur piézoélectrique (222), la première plaque isolante (223), la plaque conductrice (224) et la seconde plaque isolante (225) sont empilés l'un sur l'autre de manière séquentielle.

8. Le dispositif de dissipation de chaleur par refroidissement à l'air (2) selon la revendication 7, dans lequel le cadre externe (2222) de l'actionneur piézoélectrique (222) comprend une première broche conductrice (2222a), la plaque conductrice (224) comprend une seconde broche conductrice (224a), et l'ouverture (2263) de l'élément de couverture (226) est formée sur la paroi latérale (2261) de l'élément de couverture (226), dans lequel la première broche conductrice (2222a) et la seconde broche conductrice (224a) font saillie hors de l'ouverture (2263) de l'élément de couverture (226) de manière à être électriquement connecté à un circuit externe.

9. Le dispositif de dissipation de chaleur à refroidissement par air (2) selon l'une des revendications précédentes, comprenant en outre un système de commande (21), dans lequel le système de commande (21) comprend:
une unité de commande (211) connectée électriquement à la pompe à air (22)) pour commander le fonctionnement de la pompe à air (22); et
un capteur de température (212) connecté électriquement à l'unité de commande (211) et situé à proximité du composant électronique (3), dans lequel le capteur de température (212) détecte une température du composant électronique (3) et génère un signal de détection correspondant pour l'unité de commande (211), dans lequel l'unité de commande (211) obtient la température du composant électronique (3) en fonction du signal de détection, dans lequel si l'unité de commande (3) détermine que la température du composant électronique (3) est plus élevée ou égale à une valeur seuil, l'unité de commande (211) active la pompe à air (22) pour produire le flux d'air, si l'unité de commande (22) détermine que la température du composant électronique (3) est inférieure à la valeur seuil, l'unité de commande (211) désactive la pompe à air (22).

10. Le dispositif de dissipation de chaleur à refroidissement par air (2) selon l'une quelconque des revendications précédentes, comprenant en outre :
un puits de chaleur (5) fixé sur le dispositif électronique (3° et disposée à l'intérieur de la chambre de logement (201).

11. Le dispositif de dissipation de chaleur à refroidissement par air (2) selon l'une quelconque des revendications précédentes, comprenant en outre :
un tuyau calorifique (26) fixé sur une surface du dispositif électronique (3) et disposé à l'intérieur de la chambre de logement (201).
